(19) Europäisches Patentamt
European Patent Office
Office européen des brevets

(11) **EP 4 589 808 A1**

(12) **EUROPEAN PATENT APPLICATION**

(43) Date of publication:
**23.07.2025  Bulletin 2025/30**

(21) Application number: **24163413.8**

(22) Date of filing: **14.03.2024**

(51) International Patent Classification (IPC):
$H02J\ 13/00^{(2006.01)}$    $G01R\ 19/25^{(2006.01)}$
$G08C\ 19/02^{(2006.01)}$    $G08C\ 19/12^{(2006.01)}$
$G01R\ 25/02^{(2006.01)}$    $G01R\ 29/18^{(2006.01)}$

(52) Cooperative Patent Classification (CPC):
**H02J 13/00002; G01R 19/2513;** H02J 3/242

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **22.01.2024  IN 202441004252**

(71) Applicant: **Hitachi Energy Ltd
8050 Zürich (CH)**

(72) Inventors:
- **PRADHAN, Vedanta**
  **751024 Bhubaneswar (IN)**
- **NAIDU, Obbalareddi Demudu**
  **560087 Bangalore, Karnataka (IN)**
- **PENTA, Rithisha**
  **533003 Kakinada (IN)**

(74) Representative: **Vossius & Partner
Patentanwälte Rechtsanwälte mbB
Siebertstrasse 3
81675 München (DE)**

(54) **METHOD, DEVICE AND COMPUTER-READABLE MEDIUM FOR SYNCHRONISING DATA OF A POWER TRANSMISSION LINE**

(57)    The disclosure relates to a method for synchronising data of a power transmission line. The method comprises obtaining voltage measurements and current measurements from a local end and a remote end of the power transmission line; obtaining voltage and current phasors of the local end and the remote end using the voltage and current measurements; determining, whether synchronisation of the voltage and current measurements has been lost and determining a synchronisation angle based on the determination of whether synchronisation of the voltage and current measurements has been lost; and synchronising the voltage and current measurements using the synchronisation angle. Furthermore, a corresponding device and computer-readable storage medium are provided.

**Fig. 1**

EP 4 589 808 A1

**Description**

The present disclosure relates to a method, device and computer-readable medium for synchronising data of a power transmission line.

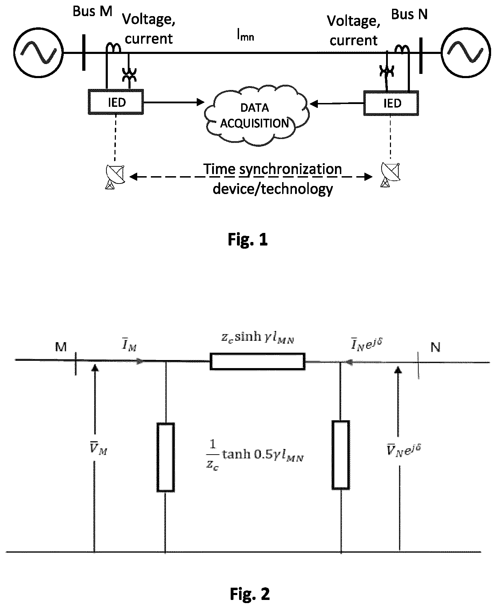

With many advancements in technology and communication, time synchronised IEDs are playing a major role in power systems. Especially, protection and monitoring algorithms for transmission lines require the voltage and current measurements from the line terminals to be time-synchronised (see Fig. 1, description below). This is a critical requirement, and loss of synchronisation can result in false outputs from algorithms such as line parameter estimation, fault location, differential and model-based protection. Loss of time synchronisation often results from issues in the related hardware, software and communication network (distributing synchronisation signals). Generally, time-synchronised data in substation systems may contain information about the quality of time-synchronisation. Notably, critical protection functions (such as line differential) are blocked upon detection of poor quality of time-synchronisation, till the source of error is detected and fixed. While blocking avoids a possible spurious/false relay operation, any fault during the blocked period remains undetected. Therefore, there is need for a method to synchronise the (unsynchronised) data which will allow protection and monitoring applications to run seamlessly without any modifications.

The problem of estimating the data synchronisation error has been approached in the existing literature in various ways. Generally, a loss of time-synchronisation between two data streams, e.g., x(t) and y(t), may be considered as a transport delay in one of them. For example, if x(t) is assumed to be properly synchronised (to a clock source), the signal y(t) may be expressed as $y(t) = \hat{y}(t - T_d)$, where $\hat{y}(t)$ is the properly synchronised version of the signal y(t). When time-domain signals are transformed to the phasor domain, the delayed phasor signal can be expressed by using the operator $e^{j\delta}$, i.e., $Y = \hat{Y}e^{j\delta}$, where the angle $\delta$ in phasor domain corresponds to the time lag $T_d$ in time-domain. For example, a 50 Hz current signal, when sampled at the rate of 1kHz, produces 20 samples per fundamental cycle (i.e., 360°). This means, a lag of one sample (or 1 ms delay), amounts to a phase angle lag of 18° in the corresponding phasor. Therefore, the expressions "synchronisation error angle $\delta$" or "synchronisation operator $e^{j\delta}$" shall be used interchangeably in the rest of the disclosure.

In [1], various approaches to calculate the synchronisation operator $e^{j\delta}$ have been discussed. A method using both local and remote ends voltages and currents is given, another method using both end voltages and one end current is given, also a method employing both end currents and one end voltage is proposed. Even though the prior two methods are using fewer measurements, all the three methods given by the author require line parameters as an input. Authors in [2] have proposed a method using symmetrical components of both ends during fault. However, the method requires solving a non-linear set of equations which is done using Newton-Raphson technique. The solution convergence depends on the initial guess. To eliminate the need for such iterations, authors in [3] have proposed a method based on a lumped model of the transmission line. In addition to that, a distributed model-based approach is given but Newton Raphson method is used to solve the approach whose initial guess is considered by solving the lumped model. A method employing distributed model and considering combination of symmetrical and superimposed components with respect to the fault type is given in [4]. All the methods [2],[3],[4] have two aspects in common. Firstly, they use measurements obtained during fault which could not be useful for the calculation of synchronisation angle during normal conditions. Secondly, all the methods require line parameters to be known. A method is proposed in [5] using two-ended voltage and current measurements during normal system conditions and based on the lumped model of the transmission line. Mitigating all the limitations in the previous approaches, a closed form solution is proposed by authors in [6] based on the equivalent $\pi$ model for distributed (long) line. A key aspect of the methods in [5] and [6] is that they are formulated in a line-parameter free approach. However, in doing so, certain assumptions are made regarding the parameters which introduce errors in the estimation of the synchronisation angle. The method in [6] is the closest prior art to the invention disclosed here. It will be later shown, how the performance of the method is highly dependent on the line loading due to the assumptions involved.

So, it would be advantageous to achieve a reliable and line parameter-free method for the calculation of the synchronisation angle. It would also be desirable to have a reliable line parameter free method for correct determination of the data synchronization error between line terminals.

There is necessity for this invention due to the limitations discussed for existing methods in the prior art. A reliable line parameter free method for the calculation of the data synchronisation error between line terminals is not available in the literature. The proposed invention describes a method which gives a reliable algorithm for the synchronisation angle calculation.

The present disclosure remedies the above problems and provides a solution to securely and efficiently determining a synchronisation angle. In particular, a methodology for compensation of the time synchronisation error which is helpful for protection and monitoring applications in transmission lines is presented.

The invention is defined in the independent claims. Dependent claims describe preferred embodiments.

To better address one or more of the above concerns, in a first aspect of the present disclosure a method is presented for synchronising data of a power transmission line. The method comprises obtaining voltage measurements and current measurements from a local end and a remote end of the power transmission line; obtaining voltage and current phasors of the local end and the remote end using the voltage and current measurements; determining, whether synchronisation of the voltage and current measurements has been lost and determining a synchronisation angle based on the determination of whether synchronisation of the voltage and current measurements has been lost; and synchronising the voltage and current measurements using the synchronisation angle.

Various embodiments may preferably implement the following features.

Preferably, the synchronisation angle is determined in case that it has been determined that the synchronisation of the voltage and current measurements has been lost.

Preferably, the synchronisation angle is determined based on a load correction constant.

Preferably, the load correction constant is independent of a line loading during unsynchronised voltage and current measurements.

Preferably, the synchronisation angle is determined based on line operational parameters of the local end and the remote end.

Preferably, the load correction constant is determined based on a load angle of the transmission line.

Preferably, the load correction constant $\mu$ is determined based on a subtraction operation of line operational parameters of the local end and the remote end during synchronous voltage and current measurements.

Preferably, the load angle is determined based on line operational parameters of the local end and the remote end.

Preferably, the line operational parameters are determined based on the voltage and current phasors of the local end and the remote end.

The present disclosure further relates to a device for synchronising data of a power transmission line comprising a processor configured to obtain voltage measurements and current measurement from a local end and a remote end of the power transmission line; obtain voltage and current phasors of the local end and the remote end using the voltage and current measurements; determine, whether synchronisation of the voltage and current measurements has been lost and determine a synchronisation angle based on the determination of whether synchronisation of the voltage and current measurements has been lost; and synchronise the voltage and current measurements using the synchronisation angle.

Various embodiments may preferably implement the following features.

Preferably, the processor is further configured to determine the synchronisation angle in case that it has been determined that the synchronisation of the voltage and current measurements has been lost.

Preferably, the processor is further configured to determine the synchronisation angle $\delta$ based on a load correction constant.

Preferably, the load correction constant is independent of a line loading during unsynchronised voltage and current measurements.

Preferably, the processor is preferably further configured to determine the synchronisation angle based on line operational parameters of the local end and the remote end.

Preferably, the processor is further configured to determine the load correction constant based on a load angle of the transmission line.

Preferably, the processor is further configured to determine the load correction constant $\mu$ based on a subtraction operation of line operational parameters of the local end and the remote end during synchronous voltage and current measurements.

Preferably, the processor is further configured to determine the load angle based on line operational parameters of the local end and the remote end.

Preferably, the processor is further configured to determine the line operational parameters based on the voltage and current phasors of the local end and the remote end.

Preferably, the device is an Intelligent Electronic Device, IED.

The present disclosure also relates to a computer-readable medium comprising instructions which, when executed by a processor, configure the processor to perform the method as described above.

The present disclosure will be further described with reference to the drawings. Therein, the same reference numerals denote the same or similar elements.

Fig. 1 shows a two-terminal system according to an embodiment.
Fig. 2 shows an equivalent $\pi$ network of a two terminal distributed line model according to an embodiment.
Fig. 3 shows a flowchart according to an embodiment of the disclosure.
Fig. 4 shows a flowchart according to an embodiment of the disclosure.

Fig. 1 shows an exemplary two-terminal system having a bus M and a bus N connected by a transmission line of length $l_{mn}$. At or close to each bus an Intelligent Electronic Device (IED) is provided. The bus at the IED forming the reference point is called the local bus while the other bus is called the remote bus. The IEDs may be communicatively coupled. For example, the IEDs may be synchronised in a wired or a wireless manner. Wireless synchronisation may be achieved, e.g., by a global navigation satellite system (GNSS) such as Global Positioning System (GPS). The IEDs may be connected to a (cloud) server or a storage medium for data acquisition.

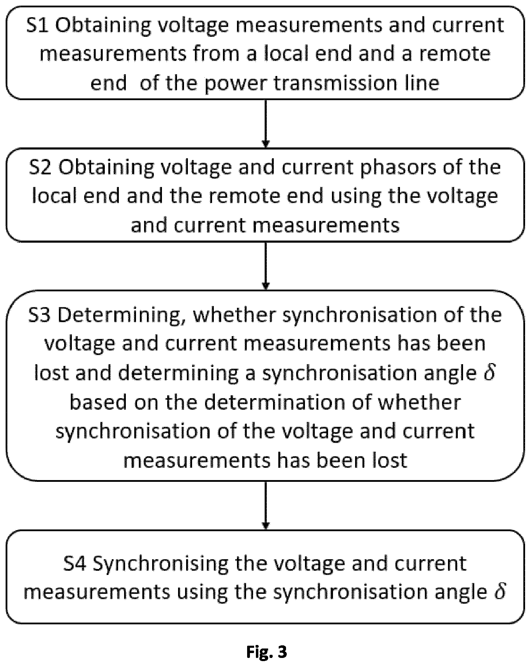

The present disclosure relates to a method for synchronising data of a power transmission line. The method as shown in Fig. 3 comprises obtaining S1 voltage measurements and current measurements from a local end and a remote end of the power transmission line, obtaining S2 voltage and current phasors of the local end and the remote end using the voltage and current measurements and determining S3, whether synchronisation of the voltage and current measurements has been lost and determining a synchronisation angle $\delta$ based on the determination of whether synchronisation of the voltage and current measurements has been lost. Further, the method comprises synchronising S4 the voltage and current measurements using the synchronisation angle $\delta$.

In an embodiment, the synchronisation angle $\delta$ is determined in case that it has been determined that the synchronisation of the voltage and current measurements has been lost.

In an embodiment, the synchronisation angle $\delta$ is determined based on a load correction constant $\mu$. In an embodiment, the load correction constant $\mu$ is independent of a line loading during unsynchronised voltage and current measurements. Therein, the line loading implies the amount of electric power carried by the line. The synchronisation angle $\delta$ may be determined based on line operational parameters of the local end and the remote end.

In an embodiment, the load correction constant $\mu$ is determined based on a load angle $\theta$ of the transmission line. The load angle may be the angle between voltage phasors at different points on the transmission line, e.g., the local bus M and the remote bus N.

In an embodiment, the load correction constant $\mu$ is determined based on a subtraction operation of line operational parameters of the local end and the remote end during synchronous voltage and current measurements. In an embodiment, the load angle $\theta$ is determined based on line operational parameters of the local end and the remote end. In an embodiment, the line operational parameters are determined based on the voltage and current phasors of the local end and the remote end.

The disclosure further relates to a corresponding device for synchronising data of a power transmission line configured to perform the method as described above. In particular, the device comprises at least one processor configured to obtain voltage measurements and current measurement from a local end and a remote end of the power transmission line, obtain voltage and current phasors of the local end and the remote end using the voltage and current measurements, determine, whether synchronisation of the voltage and current measurements has been lost and determine a synchronisation angle $\delta$ based on the determination of whether synchronisation of the voltage and current measurements has been lost and synchronise the voltage and current measurements using the synchronisation angle $\delta$.

In an embodiment, the processor is further configured to determine the synchronisation angle $\delta$ in case that it has been determined that the synchronisation of the voltage and current measurements has been lost.

In an embodiment, the processor is further configured to determine the synchronisation angle $\delta$ based on a load correction constant $\mu$. In an embodiment, the load correction constant $\mu$ is independent of a line loading during unsynchronised voltage and current measurements. The processor may further be configured to determine the synchronisation angle $\delta$ based on line operational parameters of the local end and the remote end.

In an embodiment, the processor is further configured to determine the load correction constant $\mu$ based on a load angle $\theta$ of the transmission line.

In an embodiment, the processor is further configured to determine the load correction constant $\mu$ based on a subtraction operation of line operational parameters of the local end and the remote end during synchronous voltage and current measurements. In an embodiment, the processor is further configured to determine the load angle $\theta$ based on line operational parameters of the local end and the remote end. In an embodiment, the processor is further configured to determine the line operational parameters based on the voltage and current phasors of the local end and the remote end.

The device may be an Intelligent Electronic Device, IED.

The disclosure further relates to a computer-readable medium comprising instructions which, when executed by a processor, configure the processor to perform the method as described above.

The method presented herein will be described in greater detail below.

Referring to Fig. 2, a two terminal system as shown in Fig. 1 can be represented as an equivalent $\pi$ network as shown in Fig. 2. Therein, $\bar{V}_M$, $\bar{V}_N$, $\bar{I}_M$, $\bar{I}_N$ denote the positive sequence local and remote terminal voltages and currents.

Distributed line parameter model equations can be given as below,

$$\bar{V}_N e^{j\delta} = \bar{V}_M \cosh \gamma l_{MN} - \bar{I}_M Z_c \sinh \gamma l_{MN} \qquad (1)$$

$$\bar{I}_N e^{j\delta} = = \frac{1}{Z_c} \bar{V}_M \sinh \gamma l_{MN} - \bar{I}_M \cosh \gamma l_{MN} \qquad (2)$$

In order to determine the synchronisation angle $\delta$, the following equations can be considered. Eliminating $Z_c$,

$$\cosh \gamma l_{MN} = \bar{F}_1\, e^{j\delta} + \frac{\bar{F}_2}{e^{j\delta}} \tag{3}$$

where,

$$\bar{F}_1 = \frac{\bar{V}_N \bar{I}_N}{K}\ ,\ \bar{F}_2 = \frac{-\bar{V}_M \bar{I}_M}{K} \tag{4}$$

with

$$K = (\bar{V}_M \bar{I}_N - \bar{V}_N \bar{I}_M) \tag{5}$$

where $\gamma$ denotes a positive sequence propagation constant of the line, $Z_c$ denotes a positive sequence surge impedance of the line and $l_{MN}$ denotes a length of transmission line connected between buses M and N.

Let,

$$0.5(\cosh \gamma l_{MN} - (\cosh \gamma l_{MN})^*) = j\,\mu \tag{6}$$

where, $\mu$ (imaginary part of $\cosh\gamma l_{MN}$) is a load-correction constant. The value of the load correction constant $\mu$ may be independent of the line loading and its consideration may help in derivation of a line loading independent formula for the synchronisation angle.

By substituting (3) in (6), the following can be determined.

$$e^{j2\delta}(\bar{F}_1 - \bar{F}_2^*) - j2\mu e^{j\delta} - (\bar{F}_1^* - \bar{F}_2) = 0 \tag{7}$$

$$e^{j2\delta} = \frac{(\bar{F}_1^* - \bar{F}_2) + j2\mu e^{j\delta}}{(\bar{F}_1 - \bar{F}_2^*)} \tag{8}$$

From (7), the following equation (9) is obtained.

$$e^{j\delta} = \frac{j2\mu \pm \sqrt{-4\mu^2 + 4(\bar{F}_1 - \bar{F}_2^*)(\bar{F}_1^* - \bar{F}_2)}}{2(\bar{F}_1 - \bar{F}_2^*)} \tag{9}$$

Using the synchronisation operator ($e^{j\delta}$) obtained from equation (9), the synchronisation angle $\delta = \arg(e^{j\delta})$ may be determined. A number of samples by which data is unsynchronised can also be found out as given below.

$$N_{miss} = \frac{round(\delta)}{\left(\frac{360}{n}\right)} \tag{10}$$

where n is the number of samples per fundamental cycle (e.g., 20 ms for a 50 Hz system).

The function *round(x)* denotes the mathematical operation which provides the nearest integer for the real-valued input x. A positive $N_{miss}$ means that the N side measurements need to be forward adjusted by $|N_{miss}|$ samples, and vice-versa. In equation (10), the angle $\delta$ is measured in degrees. If $\delta$ is measured in radians, 360 must be replaced by $2\pi$.

For the calculation of the synchronisation angle using equation (9), the load correction constant $\mu$ may be calculated first as follows.

Using equation (4), the below relationship can be derived:

$$(\bar{F}_1^* - \bar{F}_2) = \frac{\bar{V}_N^* \bar{V}_M (|\bar{I}_N|^2 - |\bar{I}_M|^2)}{|K|^2} - \frac{\bar{I}_N^* \bar{I}_M (|\bar{V}_N|^2 - |\bar{V}_M|^2)}{|K|^2} \tag{11}$$

Considering $|\bar{V}_N| = |\bar{V}_M|$ (typically under nominal conditions), the phase angle (say $\hat{\delta}$) of ( $\bar{F}_1^* - \bar{F}_2$ ) is the overall phase angle separation between the two end voltages, i.e., $\hat{\delta} = \delta + \theta$, where $\theta$ is the line loading angle (angle between the phasors $\overline{V}_N$ and $\overline{V}_M$ if data is synchronised). At higher loading of the line, when $|\overline{V}_N| = |\overline{V}_M|$ may not be satisfied, the angle $\theta$ may not solely represent the line load angle but is a more complicated function of both the voltage and current phasors. In the present disclosure, it is referred to as the line load or line loading angle.

From the properties of complex numbers it can be shown that,

$$e^{j2\hat{\delta}} = e^{j2(\delta+\theta)} = \frac{(\overline{F}_1^* - \overline{F}_2)}{(\overline{F}_1 - \overline{F}_2^*)} \tag{12}$$

When the data is synchronised i.e., $\delta = 0°$, then $\hat{\delta} = \theta$ and therefore under that condition $\theta$ may be found as,

$$e^{j2\theta} = \frac{(\overline{F}_1^* - \overline{F}_2)}{(\overline{F}_1 - \overline{F}_2^*)} \tag{13}$$

Dividing (8) with (12), below equation can be obtained,

$$e^{-j2\theta} = 1 + \frac{j2\mu\,e^{j\delta}}{(\overline{F}_1^* - \overline{F}_2)} \tag{14}$$

Considering synchronised data and rearranging equation (14) we obtain,

$$\mu = \theta\,e^{-j\theta}\,(\overline{F}_2 - \overline{F}_1^*) \tag{15}$$

Therefore, the value of the load-correction constant $\mu$ may be found using (15). The value $\mu$ found at a given loading condition of the line can be used for any other loading condition and does not need to be estimated repeatedly. In an embodiment, $\mu$ is determined under synchronised conditions. The load correction constant $\mu$ aids in providing fast and effective synchronisation irrespective of the actual loading condition.

By solving equation (9), two sets of synchronisation angle are obtained. Selection of the correct solution may be done using conditions as outlined below.

Two sets of line parameters can be found out by rearranging (3) and (2) and using two sets of synchronisation angles obtained solving equation (9) as below:

$$\gamma = \frac{\cosh^{-1}(\overline{F}_1 e^{j\delta} + \frac{\overline{F}_2}{e^{j\delta}})}{l_{MN}} \tag{16}$$

$$Z_c = \frac{\overline{V}_M \sinh\gamma l_{MN}}{\overline{I}_N e^{j\delta} + \overline{I}_M \cosh\gamma l_{MN}} \tag{17}$$

By using the line parameters obtained from (16) and (17), the below checks may be performed to choose the valid solution set:

$$\text{real}(\gamma^2) < 0 \text{ and } \text{real}(Z_c^2) > 0 \tag{18}$$

$$\text{imag}(\gamma^2) > 0 \text{ and } \text{imag}(Z_c^2) < 0 \tag{19}$$

If (18) and (19) are satisfied by both of the solution sets, an additional check using (20) can be done to obtain the valid solution set.

$$R > 0 \text{ and } X > 0 \text{ and } Y > 0 \tag{20}$$

where, R, X and Y are line resistance, reactance and admittance respectively. They can be derived from $\gamma$ and $Z_c$.

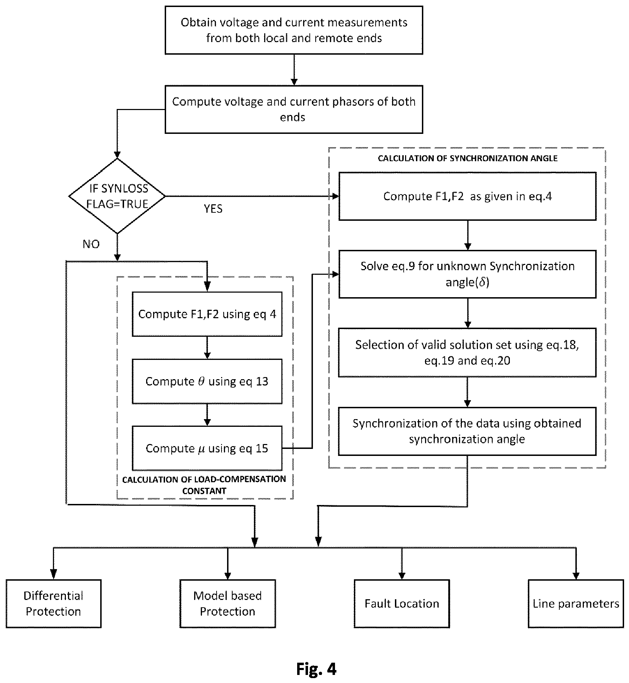

Fig. 4 is a further flowchart showing the method as outlined above. In an embodiment, the method comprises obtaining voltage and current measurements from both local and remote ends of the transmission line (i.e., at the IEDs/busses) and computing voltage and current phasors of both ends. Further, it is determined whether synchronisation has been lost. Therefore, a flag SYNLOSS may be set.

In case the measurements/phasors are synchronised (i.e., SYNLOSS = FALSE), F1 and F2 is determined using equation (4), $\theta$ is determined using equation (13) and the load correction constant $\mu$ (or load compensation constant) is determined using equation (15). As outlined above, the load correction constant $\mu$ may be determined under synchronised conditions. That is, $\mu$ may be determined when the voltage and/or current measurements (or their respective phasors) are synchronised. The load correction constant can then be reused irrespective of the load or synchronisation condition.

In case, synchronisation has been lost (SYNLOSS = TRUE), F1 and F2 are determined using equation (4) and a synchronisation angle $\delta$ is determined by solving equation (9). Using equation (18), (19) and (20), a valid solution is selected. The data is synchronised using the obtained synchronisation angle $\delta$.

Using this synchronised data, a variety of tasks such as differential protection, model-based protection, fault location or determination of line parameters may be performed.

The above method, device and computer-readable storage medium provide reliable solutions for compensating a time synchronisation error. The solution approach is independent of the line loading and also line parameter-free with no assumptions considered during formulation. The proposed method can be implemented in real-time IED as it is non-iterative as well as computationally simple. This invention is helpful to use all the existing protection and monitoring algorithms without any modifications.

According to the present disclosure, a reliable solution for synchronisation angle calculation is provided. It is a parameter free approach and doesn't have any related assumptions. Moreover, existing protection and monitoring algorithms can be used without any modifications. The method performs reliably irrespective of the loading and the synchronisation angle. The proposed method accurately estimates the data synchronisation angle, and its performance is not affected due to line loading. The proposed method is free of *a priori* information of the complete set of line parameters. It requires only one constant related to the line parameters. The constant can be estimated from a previous set of synchronised measurements (under any random loading condition) or can be obtained from the design parameters of the line (if available). The proposed method constitutes a method which is independent of line-loading. This is achieved by first estimating the line-loading independent constant (as mentioned previously) and compensating for the line-loading factor in the derived closed-loop formula for synchronisation angle. The proposed algorithm is noniterative and computationally simple to be implemented on real-time IED CPU.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

List of cited references

[1] M. M. Saha, J. Izykowski and E. Rosolowski, Fault Location on Power Networks, London, U.K.:Springer, 2010.

[2] D. Novosel, D. G. Hart, E. Udren and J. Garitty, "Unsynchronized two-terminal fault location estimation," in IEEE Transactions on Power Delivery, vol. 11, no. 1, pp. 130-138, Jan. 1996, doi: 10.1109/61.484009.

[3] J. Izykowski, R. Molag, E. Rosolowski and M. M. Saha, "Accurate location of faults on power transmission lines with use of two-end unsynchronized measurements," in IEEE Transactions on Power Delivery, vol. 21, no. 2, pp. 627-633, April 2006, doi: 10.1109/TPWRD.2005.858778.

[4] J. Izykowski, E. Rosolowski, P. Balcerek, M. Fulczykand M. M. Saha, "Accurate Noniterative Fault Location Algorithm Utilizing Two-End Unsynchronized Measurements," in IEEE Transactions on Power Delivery, vol. 25, no. 1, pp. 72-80, Jan. 2010, doi: 10.1109/TPWRD.2009.2035222.

[5] P. Dawidowski, J. Iżykowski and A. Nayir, "Non-iterative algorithm of analytical synchronization of two-end measurements for transmission line parameters estimation and fault location," 2011 7th International Conference on Electrical and Electronics Engineering (ELECO), Bursa, 2011, pp. I-76-I-79.

[6] K. Kalita, S. Anand and S. K. Parida, "A Closed Form Solution for Line Parameter-Less Fault Location With Unsynchronized Measurements," in IEEE Transactions on Power Delivery, vol. 37, no. 3, pp. 1997-2006, June 2022, doi: 10.1109/TPWRD.2021.3102181.

**Claims**

1. Method for synchronising data of a power transmission line, the method comprising:

   obtaining voltage measurements and current measurements from a local end and a remote end of the power transmission line;
   obtaining voltage and current phasors of the local end and the remote end using the voltage and current measurements;
   determining whether synchronisation of the voltage and current measurements has been lost and determining a synchronisation angle $\delta$ based on the determination of whether synchronisation of the voltage and current measurements has been lost,
   wherein the synchronisation angle $\delta$ is determined based on a load-correction constant $\mu$; and
   synchronising the voltage and current measurements using the synchronisation angle $\delta$.

2. Method according to claim 1, wherein the synchronisation angle $\delta$ is determined in case that it has been determined that the synchronisation of the voltage and current measurements has been lost.

3. Method according to claim 1 or 2, wherein the load correction constant $\mu$ is independent of a line loading during unsynchronised voltage and current measurements,
   wherein preferably, the synchronisation angle $\delta$ is determined based on line operational parameters of the local end and the remote end.

4. Method according to any one of claims 1 to 3, wherein the load correction constant $\mu$ is determined based on a load angle $\theta$ of the transmission line.

5. Method according to any one of claims 1 to 4, wherein the load correction constant $\mu$ is determined based on a subtraction operation of line operational parameters of the local end and the remote end during synchronous voltage and current measurements.

6. Method according to claim 4 or 5, wherein the load angle $\theta$ is determined based on line operational parameters of the local end and the remote end.

7. Method according to any one of claims 3 to 6, wherein the line operational parameters are determined based on the voltage and current phasors of the local end and the remote end.

8. Device for synchronising data of a power transmission line comprising a processor configured to:

   obtain voltage measurements and current measurement from a local end and a remote end of the power transmission line;
   obtain voltage and current phasors of the local end and the remote end using the voltage and current measurements;
   determine, whether synchronisation of the voltage and current measurements has been lost and determine a synchronisation angle $\delta$ based on the determination of whether synchronisation of the voltage and current measurements has been lost,
   wherein the synchronisation angle $\delta$ is determined based on a load-correction constant $\mu$; and;
   synchronise the voltage and current measurements using the synchronisation angle $\delta$.

9.  Device according to claim 8, wherein the processor is further configured to determine the synchronisation angle $\delta$ in case that it has been determined that the synchronisation of the voltage and current measurements has been lost.

10. Device according to claim 8 or 9, wherein the load correction constant $\mu$ is independent of a line loading during unsynchronised voltage and current measurements,
    wherein the processor is preferably further configured to determine the synchronisation angle $\delta$ based on line operational parameters of the local end and the remote end.

11. Device according to any one of claims 8 to 10, wherein the processor is further configured to determine the load correction constant $\mu$ based on a load angle $\theta$ of the transmission line.

12. Device according to any one of claims 8 to 11, wherein the processor is further configured to determine the load correction constant $\mu$ based on a subtraction operation of line operational parameters of the local end and the remote end during synchronous voltage and current measurements, and/or
    wherein the processor is further configured to determine the load angle $\theta$ based on line operational parameters of the local end and the remote end.

13. Device according to any one of claims 10 to 12, wherein the processor is further configured to determine the line operational parameters based on the voltage and current phasors of the local end and the remote end.

14. Device according to any one of claims 8 to 13, wherein the device is an Intelligent Electronic Device, IED.

15. Computer-readable medium comprising instructions which, when executed by a processor, configure the processor to perform the method according to any one of claims 1 to 7.

**Fig. 1**

**Fig. 2**

S1 Obtaining voltage measurements and current measurements from a local end and a remote end of the power transmission line

S2 Obtaining voltage and current phasors of the local end and the remote end using the voltage and current measurements

S3 Determining, whether synchronisation of the voltage and current measurements has been lost and determining a synchronisation angle $\delta$ based on the determination of whether synchronisation of the voltage and current measurements has been lost

S4 Synchronising the voltage and current measurements using the synchronisation angle $\delta$

**Fig. 3**

Fig. 4

Europäisches
Patentamt

European
Patent Office

Office européen
des brevets

## EUROPEAN SEARCH REPORT

**Application Number**

EP 24 16 3413

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RITHISHA PENTA ET AL: "A practical methodology for fault location in transmission lines without line parameter settings and data synchronization", 17TH INTERNATIONAL CONFERENCE ON DEVELOPMENTS IN POWER SYSTEM PROTECTION (DPSP 2024), 7 March 2024 (2024-03-07), pages 187-193, XP093190714, DOI: 10.1049/icp.2024.0896 Retrieved from the Internet: URL:https://ieeexplore.ieee.org/stampPDF/g etPDF.jsp?tp=&arnumber=10542913&ref=aHR0cH M6Ly9pZWVleHBsb3JlLmllZWUub3JnL2RvY3VtZW50 LzEwNTQyOTEz> * Section 3; figure 2 * | 1-15 | INV. H02J13/00 G01R19/25 G08C19/02 G08C19/12 ADD. G01R25/02 G01R29/18 |
| X | US 2017/003335 A1 (KANG NING [US] ET AL) 5 January 2017 (2017-01-05) * paragraph [0059]; figure 7 * | 1,8 | |
| X | LU DIAN ET AL: "Parameter-Free Virtual Synchronization Technique for Terminals of Power Transmission Lines", 2023 IEEE PES GTD INTERNATIONAL CONFERENCE AND EXPOSITION (GTD), IEEE, 22 May 2023 (2023-05-22), pages 288-292, XP034436213, DOI: 10.1109/GTD49768.2023.00081 [retrieved on 2023-09-29] * Section II * | 1,8 | TECHNICAL FIELDS SEARCHED (IPC) H02J G01R G08C |

-/--

The present search report has been drawn up for all claims

| Place of search | Date of completion of the search | Examiner |
|---|---|---|
| Munich | 30 July 2024 | Ríos Báez, Abel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 24 16 3413

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KALITA KAUSTAV ET AL: "A Closed Form Solution for Line Parameter-Less Fault Location With Unsynchronized Measurements", IEEE TRANSACTIONS ON POWER DELIVERY, IEEE SERVICE CENTER, NEW YORK, NY, US, vol. 37, no. 3, 4 August 2021 (2021-08-04), pages 1997-2006, XP011909029, ISSN: 0885-8977, DOI: 10.1109/TPWRD.2021.3102181 [retrieved on 2021-08-04] * Section II * ----- | 1,8 | |
| | | | **TECHNICAL FIELDS SEARCHED (IPC)** |

The present search report has been drawn up for all claims

| Place of search | Date of completion of the search | Examiner |
|---|---|---|
| Munich | 30 July 2024 | Ríos Báez, Abel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 3413

This annex lists the patent family members relating to the patent documents cited in the above-mentioned European search report.
The members are as contained in the European Patent Office EDP file on
The European Patent Office is in no way liable for these particulars which are merely given for the purpose of information.

30-07-2024

| Patent document cited in search report | Publication date | Patent family member(s) | Publication date |
|---|---|---|---|
| US 2017003335 A1 | 05-01-2017 | NONE | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. M. SAHA** ; **J. IZYKOWSKI** ; **E. ROSOLOWSKI**. Fault Location on Power Networks. Springer, 2010
- **D. NOVOSEL** ; **D. G. HART** ; **E. UDREN** ; **J. GARITTY**. Unsynchronized two-terminal fault location estimation. *IEEE Transactions on Power Delivery*, January 1996, vol. 11 (1), 130-138
- **J. IZYKOWSKI** ; **R. MOLAG** ; **E. ROSOLOWSKI** ; **M. M. SAHA**. Accurate location of faults on power transmission lines with use of two-end unsynchronized measurements. *IEEE Transactions on Power Delivery*, April 2006, vol. 21 (2), 627-633
- **J. IZYKOWSKI** ; **E. ROSOLOWSKI** ; **P. BALCEREK** ; **M. FULCZYKAND M. M. SAHA**. Accurate Noniterative Fault Location Algorithm Utilizing Two-End Unsynchronized Measurements. *IEEE Transactions on Power Delivery*, January 2010, vol. 25 (1), 72-80
- **P. DAWIDOWSKI, J. IŻYKOWSKI** ; **A. NAYIR**. Noniterative algorithm of analytical synchronization of two-end measurements for transmission line parameters estimation and fault location. *2011 7th International Conference on Electrical and Electronics Engineering (ELECO)*, 2011, I-76-I-79
- **K. KALITA** ; **S. ANAND** ; **S. K. PARIDA**. A Closed Form Solution for Line Parameter-Less Fault Location With Unsynchronized Measurements. *IEEE Transactions on Power Delivery*, June 2022, vol. 37 (3), 1997-2006